**Europäisches Patentamt**

**European Patent Office**

**Office européen des brevets**

(11) Veröffentlichungsnummer: **0 166 110 B1**

# EUROPÄISCHE PATENTSCHRIFT

(45) Veröffentlichungstag der Patentschrift: **12.12.90**

(51) Int. Cl.⁵: **H 05 K 3/40**

(21) Anmeldenummer: **85105125.0**

(22) Anmeldetag: **26.04.85**

(54) **Leiterplattenanordnung.**

(30) Priorität: **27.06.84 DE 3423648**

(43) Veröffentlichungstag der Anmeldung:
**02.01.86 Patentblatt 86/01**

(45) Bekanntmachung des Hinweises auf die
Patenterteilung:
**12.12.90 Patentblatt 90/50**

(84) Benannte Vertragsstaaten:
**AT CH DE FR GB IT LI NL SE**

(56) Entgegenhaltungen:
**FR-A-1 521 897**
**FR-A-2 258 716**

(73) Patentinhaber: **C.A. Weidmüller GmbH & Co.**
**Postfach 950 Paderborner Strasse 175**
**D-4930 Detmold 14 (DE)**

(72) Erfinder: **Haller, Bernd**
**Schau ins Land 7**
**D-4930 Detmold (DE)**

(74) Vertreter: **Loesenbeck, Karl-Otto, Dipl.-Ing. et al**
**Jöllenbecker Strasse 164**
**D-4800 Bielefeld 1 (DE)**

Courier Press, Leamington Spa, England.

## Beschreibung

Die vorliegende Erfindung betrifft eine Leiterplattenanordnung, bestehend aus einer Leiterplatte mit einem vorgegebenen Raster von Aufnahmen und aus darauf angeordneten elektrisch-elektronischen, mit einem Isolierstoffgehäuse versehenen Bauteilen mit Lötanschlüssen.

Leiterplatten sind üblicherweise mit in einem vorbestimmten Raster versehenen Aufnahmen in Form von Löchern versehen, in die darauf anzuordnende elektrisch-elektronische Bauteile mit den Stiften ihres Lötanschlusses entsprechend der jeweiligen Schaltungsanordnung eingesteckt und dann verlötet werden. Betroffen sind hier dabei derartige elektrische- elektronische Bauteile, die mit einem Isolierstoffgehäuse versehen sind, aus dem die Stifte der Lötanschlüsse vorstehen, also beispielsweise Anschlußklemmen für gedruckte Schaltungen (DE—AS 27 36 620), oder aber blokkartig zusammensetzbare oder von vornherein in vorbestimmter Polzahl einstückige Steckverbinderleisten (DE—AS 12 68 707, DE—OS 25 00 141).

Das bekannte und gängige Rastermaß bei den bekannten Leiterplatten ist nun so ausgelegt, daß der hieraus resultierende relativ geringe Abstand zwischen den Stiften der Lötanschlüsse bei einer Anreihung derartiger Anschlußklemmen oder bei einer Vielzahl von Stiften einer langen Steckverbinderleiste bei höheren Anforderungen an die Größe der Kriechstrecke problematisch wird. Es ist dabei darn zu denken, daß man zwar auf der Unterseite der Leiterplatten, dort wo die durchgesteckten Lötstifte verlötet werden, das Kriechstrekken-Problem mit einem Isolier-Schutzlack lösen kann, daß aber auf der Oberseite der Lieterplatte, dort, wo die Isolierstoffgehäuse der Bauteile auf der Oberfläche der Leiterplatte sitzen, doch immer ein kleiner, wenn auch kaum sichtbarer Spalt zwischen der Unterseite der Isolierstoffgehäuse der Bauteile und der Oberfläche der Leiterplatte verbleibt und dieser Spalt als Kriech- und Luftstrecke zu berücksichtigen ist.

Problematisch wird das Kriech- und Luftstrekken-Problem insbesondere dann, wenn herkömmliche Leiterplatten mit dem üblichen Rastermaß bei sogenannten Eigenschutzanlagen Einsatz finden sollen, bei denen mit einer Anordnung beispielsweise in einem hochentzündlichen Gemisch gerechnet werden muß.

Es könnte nun daran gedacht werden, für diese Einsatzzwecke spezielle Leiterplattenausgestaltungen mit entsprechend deutlich vergrößertem Rastermaß bei den Aufnahmen und entsprechend angepaßte aufzunehmende Bauteil mit entsprechend großem Lötstiftabstand vorzusehen, was jedoch eine spezielle, äußerst umzweckmäßige Fertigung und Lagerhaltung erfordern würde.

Der vorliegenden Erfindung liegt von daher die Aufgabe zugrunde, eine Leiterplattenanordnung der gattungsgemäßen Art zu schaffen, die unter Verwendung der handelsüblichen Leiterplatten es ermöglicht, im Bedarfsfall in einfacher Weise Kriech- und Luftstreckenvergrößerungen zu erreichen.

Die erindungsgemäße Lösung besteht darin, daß in der Leiterplatte in Anordnungsrichtung der Lötanschlüsse jeweils zwischen den Aufnahmen oder zwischen vorgegebenen Aufnahmegruppen Aussparungen vorgesehen sind und ferner darin eingesteckte Trennwandstücke aus Isolierstoff vorgesehen sind, die mit den Isolierstoffgehäusen der Bauteil verbunden sind.

Dank der in die Aussparungen der Leiterplatte einzusetzenden Trennwandstücke läßt sich nunmehr auf sehr einfache Weise im Bedarfsfall die auf der Oberfläche der Leiterplatte zu berücksichtigende Kriech- und Luftstrecke zwischen zwei Lötstiften außerordentlich vergrößern. Der Berechnung ist nämlich nunmehr der Weg zugrundezulegen, der zwischen zwei vorgegebenen Lötstiften um diese Trennwandstücke herumführt. Es kann dabei daran gedacht werden, Bauteile, beispielsweise Anschlußklemmen oder Steckverbinderleisten vorzusehen, bei denen die Trennwandstücke von vornherein einstückig an entsprechender Stelle an deren Isolierstoffgehäuse angeformt sind. Noch zweckmäßiger ist jedoch eine Ausgestaltung, bei der in die Isolierstoffgehäuse lediglich Aussparungen eingeformt sind, in die gesonderte einzelne Trennwandstücke mit entsprechender Ausgestaltung rasten oder schnappend-verriegelnd eingesetzt werden können. Im letzteren Fall können die Bauteile mit ihren Isolierstoffgehäusen völlig einheitlich für Einsatzfälle ohne Kriechstrecken-Vergrößerung sowie auch für den Einsatzbereich mit Kriechstrecken-Vergrößerung eingesetzt werden, wobei im letzteren Fall dann lediglich an den erforderlichen Stellen die Trennwandstücke eingerastet werden.

Gemäß einer weiteren zweckmäßigen Ausgestaltung ist vorgesehen, die im Randbereich der Leiterplatte vorgesehenen Aussparungen für die Trennwandstücke zum Rand hin offen auszubilden. Dies führt zur Montageerleichterung bei der Anbringung der Trennwandstücke.

Ausführungsbeispiele von Leiterplattenanordnungen gemäß der Erfindung werden nachstehend unter Bezugnahme auf die Zeichnung näher beschrieben.

Es zeigen

Figur 1 eine schematisierte Teildraufsicht auf eine Leiterplatte einer derartigen Leiterplattenanordnung,

Figur 2 eine schematisierte Teildraufsicht auf eine weitere derartige Leiterplatte,

Figur 3 eine auf einer Leiterplatte angeordnete Anreihung von elektrisch-elektronischen Bauteilen einer derartigen Anordnung,

Figur 4 eine weitere Ausführungsform derartiger Bauteile,

Figur 5 Einzelansicht verschiedener Trennwandstücke für eine derartige Leiterplattenanordnung.

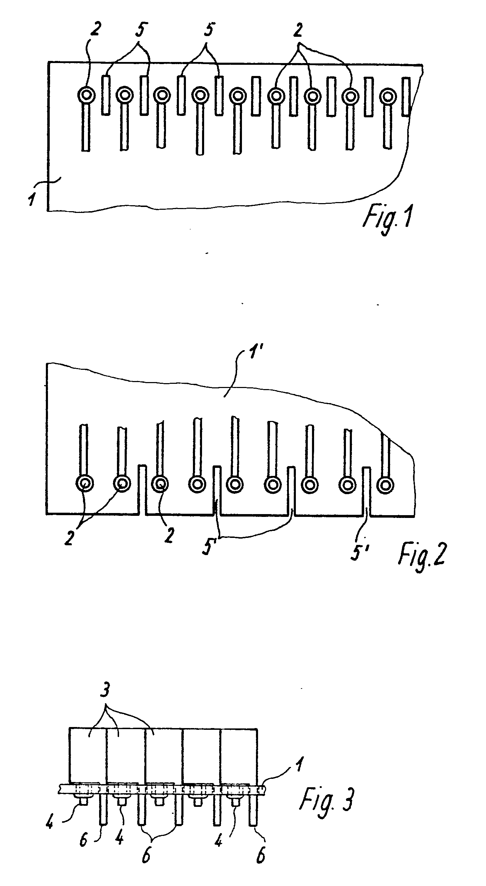

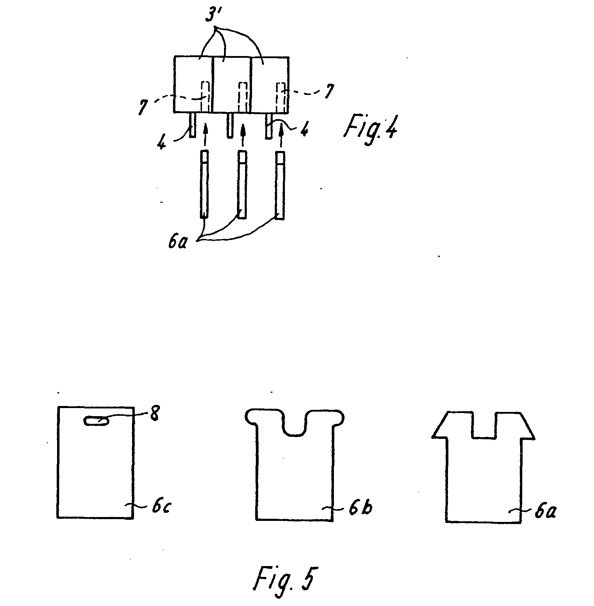

Die Leiterplattenanordnung beinhaltet eine Leiterplatte, wie die in zwei Ausführungsformen mit den Leiterplatten 1 und 1' in den Figuren 1 und 2 dargestellt ist. Die Leiterplatte 1 hat die üblichen Löcher 2 als Aufnahmen für die Lötanschlüsse der aufzubringenden Bauteile, wobei sich diese Aufnahmen 2 voneinander in einem Abstand entsprechend dem handelsüblichen Rastermaß bei derartigen Leiterplatten befinden. Aus diesem Rastermaß resultieren bei einer Anreihung von aufzubringenden Bauelementen dann auch die Abstände, die die Lötstifte voneinander haben, wie dies beispielsweise in Figure 3 für die dort als elektrisch-elektronische Bauteil vorgesehenen Anschlußklemmen 3 gezeigt ist, deren Lötstifte 4 einen entsprechenden Abstand voneinander haben. In Figur 3 ist dabei auch illustriert, daß sich nach Aufsetzen der Bauteile 3 auf die Leiterplatte 1 zwischen der Unterseite der Isolierstoffgehäuse der Bauteile 3, aus der die Lötstifte 4 vorstehen, und der Oberfläche der Leiterplatte 1 ein Luftspalt bildet, der in der Praxis häufig mit dem Auge kaum wahrnehmbar ist, der aber bei der Berechnung der Kriech- und Luftstrecken durchaus berücksichtigt werden muß.

Es ist nun vorgesehen, in den Leiterplatten 1, 1' in Anordnungsrichtung der Lötanschlüsse der Bauteile zwischen den Aufnahmen 2, und zwar beispielsweise (Figur 1) zwischen jeder der Aufnahmen 2, schlitzförmige Aussparungen 5 vorzusehen. Bei der Ausführungsform nach Figur 2 sind in der Leiterplatte 1' jeweils zwischen einer Gruppe von zwei Aufnahmen 2 Schlitze vorgesehen, wobei im Ausführungsbeispiel nach Figur 2 im dort dargestellten Randbereich der Leiterplatte 1' schlitzförmige Aufnahmen 5' vorgesehen, die zum Rand hin offen sind.

In diese schlitzförmigen Aufnahmen 5 bzw. 5' können nun Trennwandstücke eingesteckt werden, die im Ausführungsbeispiel nach Figur 3 als an die Isolierstoffgehäuse der elektrisch-elektronischen Bauteile 3 unterseitig angeformte Trennwandstücke 6 ausgebildet sind, während im Ausführungsbeispiel nach Figur 4 elektrisch-elektronische Bauelement 3' gezeigt sind, die jeweils mit einer Aussparung 7 versehen sind, in die gesonderte einzelne Trennwandstücke 6a im Bedarfsfall schnappend-verriegelnd eingesetzt werden können. Einige derartige gesonderte Trennwandstücke 6a, 6b, 6c sind in Figur 5 illustriert. Während die Trennwandstücke 6a und 6b über einen Schlitz abgefederte obere Rastnasen haben, weist das Trennwandstück 6c in seinem oberen Bereich auf seinen Wandflächen angeordnete vorstehende Rastnoppen 8 auf. Die Aufnahmen 7 der Bauteile 3' sind jeweils entsprechend der Ausgestaltung der Trennwandstücke mit entsprechend geformten Gegenelementen für die schnappend-verriegelnde Aufnahme versehen.

Also auf der Leiterplatte 1, 1' anzubringende elektrisch-elektronische Bauteile kommen insbesondere Anschlußklemmen 3, 3' in Betracht, oder aber anschlußklemmenartig ausgebildete Bauteile mit einem entsprechenden Isolierstoffgehäuse und Lötstiften, sowie ferner mehrpolige Steckverbinderleisten, die entweder von vornherein einstückig in entsprechender Polzahl ausgebildet sind, oder aus einzelnen Elementen zu Blocks der gewünschten Polzahl zusammengesteckt werden können. Auch hier sind dann wieder Isolierstoffgehäuse vorhanden, aus denen in entsprechender Anzahl und in entsprechendem Abstand Lötstifte vorstehen.

Die Trennwände 6, 6a, 6b, 6c, seine sie nun an die Isolierstoffgehäuse angeformt, oder aber in besonders zweckmäßiger Ausgestaltung mit diesen verrastbar, bewirken eine außerordentliche Kriech- und Luftstreckenvergrößerung zwischen betroffenen Lötstiften, da für deren Berechnung jetzt ein Weg, der um die Trennwandstücke herumführt, zugrundezulegen ist. Es versteht sich dabei, daß auch die gesonderten einzelnen Trennwandstücke aus einem Isolierstoff bestehen.

## Patentansprüche

1. Leiterplattenanordnung, bestehend aus einer Leiterplatte mit einem vorgegebenen Raster von Aufnahmen und aus darauf angeordneten, elektrisch-elektronischen, mit einem Isolierstoffgehäuse versehenen Bauteilen mit Lötanschlüssen, die in die Leiterplattenaufnahmen gesteckt werden, dadurch gekennzeichnet, daß in der Leiterplatte (1, 1') in Anordnungsrichtung der Lötanschlüsse (4) jeweils zwischen den Aufnahmen (2) oder zwischen vorgegebenen Aufnahmegruppen Aussparungen (5, 5') vorgesehen sind und ferner darin eingesteckte Trennwandstücke (6, 6a, 6b, 6c) aus Isolierstoff vorgesehen sind, die mit den Isolierstoffgehäusen der Bauteile (3, 3') verbunden sind.

2. Leiterplattenanordnung nach Anspruch 1, dadurch gekennzeichnet, daß die Trennwandstücke (6) einstückig an die Isolierstoffgehäuse der Bauteile (3) angeformt sind.

3. Leiterplattenanordnung nach Anspruch 1, dadurch gekennzeichnet, daß die Bauteile (3') in ihren Isolierstoffgehäusen jeweils Aufnahmeaussparungen (7) aufweisen, in denen die Trennwandstücke (6a, 6b, 6c) vorrastet sind.

4. Leiterplattenanordnung nach Anspruch 1, dadurch gekennzeichnet, daß die im Randbereich der Leiterplatte (1') vorgesehenen Aussparungen (5') für die Trennwandstücke (6, 6a, 6b, 6c) zum Rand hin offen sind.

5. Leiterplattenanordnung nach einem oder mehreren der vorhergehenden Ansprüche, dadurch gekennzeichnet, daß die die elektrischenelektronische Bauteile Anschlußklemmen sind.

6. Leiterplattenanordnung nach einem oder mehreren der Ansprüche 1—4, dadurch gekennzeichnet, daß die elektrisch-elektronischen Bauteile Steckverbinderleisten sind.

## Revendications

1. Dispositif de plaquette de circuits constitué d'une plaquette de circuits comportant des logements, suivant un module donné, ainsi que de composants électriques et électroniques, disposés sur la plaquette, pourvus d'un boîtier isolant, avec des connexions soudées qui sont enfichées dans les logements de la plaquette de circuits, caractérisé en ce qu'on prévoit des évidements (5, 5'), dans la plaquette de circuits (1, 1'), dans la direction de disposition des connexions soudées (4), entre les logements (2) ou entre des groupes de logements donnés et en ce qu'on prévoit, en outre, des pièces de cloisonnement (6, 6a, 6b, 6c) en matière isolante, enfichées dans ces évidements et qui sont reliées aux boîtiers isolants des composants (3, 3').

2. Dispositif de plaquette de circuits selon la revendication 1, caractérisé en ce que les pièces de cloisonnement (6) sont venues de moulage, d'une seule pièce, avec les boîtiers isolants des composants (3).

3. Dispositif de plaquette de circuits selon la revendication 1, caractérisé en ce que les composants (3') présentent, dans leurs boîtier isolant respectif, des évidements servant de logements (7) dans lesquels les pièces de cloisonnement (6a, 6b, 6c) sont encliquetées.

4. Dispositif de plaquette de circuits selon la revendication 1, caractérisé en ce que les évidements (5'), prévus dans la région de bordure de la plaquette de circuits (1'), destinés aux pièces de cloisonnement (6a, 6b, 6c), sont ouverts vers le bord.

5. Dispositif de plaquette de circuits selon une ou plusieurs des revendications précédentes, caractérisé en ce que les composants électriques et électroniques sont des bornes de connexion.

6. Dispositif de plaquette de circuits selon une ou plusieurs des revendications 1 à 4, caractérisé en ce que les composants électriques et électroniques sont des barrettes de connecteur à fiches.

**Claims**

1. A printed circuit board arrangement comprising a printed circuit board with a predetermined pattern of mountings and electrical-electronic components which are arranged thereon and which are provided with an insulating material casing, with solder terminals which are fitted into the printed circuit board mountings, characterised in that openings (5, 5') are provided in the printed circuit board (1, 1') in the direction of the arrangement of the solder terminals (4) between the respective mountings (2) or between respective predetermined groups of mountings and there are also provided separating wall portions (6, 6a, 6b, 6c) of insulating material which are fitted into said openings and which are connected to the insulating material casings of the components (3, 3').

2. A printed circuit board arrangement according to claim 1 characterised in that the separating wall portions (6) are formed integrally on the insulating material casings of the components (3).

3. A printed circuit board arrangement according to claim 1 characterised in that in their insulating material casings the components (3') have respective mounting openings (7) in which the separating wall portions (6a, 6b, 6c) are located.

4. A printed circuit board arrangement according to claim 1 characterised in that the openings (5') which are are provided in the edge region of the printed circuit board (1') for the separating wall portions (6, 6a, 6b, 6c) are open towards the edge.

5. A printed circuit board arrangement according to one or more of the preceding claims characterised in that the electrical-electronic components are terminal clamps.

6. A printed circuit board arrangement according to one or more of claims 1 to 4 characterised in that the electrical-electronic components are multipoint connectors.

Fig.1

Fig.2

Fig. 3

Fig. 4

Fig. 5